# EUROPEAN PATENT SPECIFICATION

(11) **EP 3 087 733 B1**
(45) Date of publication and mention of the grant of the patent: **09.10.2019**
(21) Application number: 15765348.6
(22) Date of filing: 18.03.2015
(51) Int. Cl.: G06F 3/14

(54) **DATA PROCESSING APPARATUS FOR TRANSMITTING/RECEIVING COMPRESSED DISPLAY DATA WITH IMPROVED ERROR ROBUSTNESS AND RELATED DATA PROCESSING METHOD**
DATENVERARBEITUNGSVORRICHTUNG ZUM SENDEN/EMPFANGEN KOMPRIMIERTER ANZEIGEDATEN MIT VERBESSERTER FEHLERROBUSTHEIT UND ENTSPRECHENDES DATENVERARBEITUNGSVERFAHREN
APPAREIL DE TRAITEMENT DE DONNÉES PERMETTANT DE TRANSMETTRE/RECEVOIR DES DONNÉES D'AFFICHAGE COMPRESSÉES AVEC UNE ROBUSTESSE AUX ERREURS AMÉLIORÉE ET PROCÉDÉ DE TRAITEMENT DE DONNÉES ASSOCIÉ

(30) Priority: 18.03.2014 US 201461954667 P
(43) Date of publication of application: 02.11.2016
(73) Proprietor: MediaTek Inc., Hsin-Chu (TW)
(72) Inventor: JU, Chi-Cheng, Hsinchu City (TW); LIU, Tsu-Ming, Hsinchu City (TW)
(74) Representative: Hoefer & Partner Patentanwälte mbB
(86) International application number: PCT/CN2015/074430
(87) International publication number: WO 2015/139626

(56) References cited:
- WO-A1-2014/056406
- CN-A- 101 110 958
- CN-A- 102 681 812
- US-A1- 2011 310 980
- US-A1- 2011 310 980
- US-A1- 2013 235 039
- US-A1- 2013 322 515
- LAWRENCE R: "High-speed serial interface for mobile displays", PROCEEDINGS OF THE 13TH INTERNATIONAL DISPLAY WORKSHOPS : DEC. 6 - 8, 2006, OTSU PRINCE HOTEL, OTSU, JAPAN, TOKYO : ITE ; SAN JOSE, CALIF. : SID, JP, vol. 3, 6 December 2006 (2006-12-06), pages 2013-2016, XP008130948,
- MEEHAN J ET AL: "Multimedia IP architecture trends in the mobile multimedia consumer device", SIGNAL PROCESSING. IMAGE COMMUNICATION, ELSEVIER SCIENCE PUBLISHERS, AMSTERDAM, NL, vol. 25, no. 5, 1 June 2010 (2010-06-01), pages 317-324, XP027080310, ISSN: 0923-5965, DOI: 10.1016/J.IMAGE.2010.04.001 [retrieved on 2010-04-21]
- PIERRE DE GREEF ET AL: "P-49: Integrated Display Port TCON Device with Vibrant Picture Quality Features", SID 2009, 2009 SID INTERNATIONAL SYMPOSIUM, SOCIETY FOR INFORMATION DISPLAY, LOS ANGELES, USA, vol. XXXX, 31 May 2009 (2009-05-31), pages 1275-1278, XP007017408, ISSN: 0009-966X

## Description

### BACKGROUND

The disclosed embodiments of the present invention relate to transmitting display data over a display interface, and more particularly, to a data processing apparatus for transmitting/receiving compressed display data with improved error robustness and a related data processing method.

A display interface is disposed between a first chip and a second chip to transmit display data from the first chip to the second chip for further processing. For example, the first chip may be a host application processor, and the second chip may be a driver integrated circuit (IC). The display data may include image data, video data, graphic data, and/or OSD (on-screen display) data. Besides, the display data may be single view data for two-dimensional (2D) display or multiple view data for three-dimensional (3D) display. When a display panel supports a higher display resolution, 2D/3D display with higher resolution can be realized. Hence, the display data transmitted over the display interface would have a larger data size/data rate, which increases the power consumption of the display interface inevitably. If the host application processor and the driver IC are both located at a portable device (e.g., a smartphone) powered by a battery device, the battery life is shortened due to the increased power consumption of the display interface. Thus, there is a need for an innovative design which can effectively reduce the power consumption of the display interface.

The features of the preamble portions of the independent claims of this application are disclosed in US 2013/322515 A1.

### SUMMARY

In accordance with exemplary embodiments of the present invention, a data processing apparatus for transmitting/receiving compressed display data with improved error robustness and a related data processing method are proposed.

According to a first aspect of the present invention, an exemplary data processing apparatus is disclosed. The exemplary data processing apparatus includes a compressor and an output interface. The compressor is arranged to perform compression upon an input display data to generate a compressed display data, wherein an error-resilient coding tool is involved in the compression. The output interface is arranged to pack an output display data derived from the compressed display data into an output bitstream, and output the output bitstream via a display interface, wherein the display interface is one of a display serial interface (DSI) standardized by a Mobile Industry Processor Interface (MIPI) and an embedded display port (eDP) standardized by a Video Electronics Standards Association (VESA).

According to a second aspect of the present invention, an exemplary data processing apparatus is disclosed. The exemplary data processing apparatus includes an input interface and a de-compressor. The input interface is arranged to receive an input bitstream from a display interface, and un-pack the input bitstream into an input display data, wherein the display interface is one of a display serial interface (DSI) standardized by a Mobile Industry Processor Interface (MIPI) and an embedded display port (eDP) standardized by a Video Electronics Standards Association (VESA). The de-compressor is arranged to perform decompression upon a compressed display data derived from the input display data to generate a de-compressed display data, wherein an error detection and an error concealment are involved in the decompression.

According to a third aspect of the present invention, an exemplary data processing method is disclosed. The exemplary data processing method includes: utilizing a compressor to perform compression upon an input display data to generate a compressed display data, wherein an error-resilient coding tool is involved in the compression; packing an output display data derived from the compressed display data into an output bitstream; and outputting the output bitstream via a display interface, wherein the display interface is one of a display serial interface (DSI) standardized by a Mobile Industry Processor Interface (MIPI) and an embedded display port (eDP) standardized by a Video Electronics Standards Association (VESA).

According to a fourth aspect of the present invention, an exemplary data processing method is disclosed. The exemplary data processing method includes: receiving an input bitstream from a display interface, wherein the display interface is one of a display serial interface (DSI) standardized by a Mobile Industry Processor Interface (MIPI) and an embedded display port (eDP) standardized by a Video Electronics Standards Association (VESA); un-packing the input bitstream into an input display data; and utilizing a de-compressor to perform decompression upon a compressed display data derived from the input display data and generate a de-compressed display data, wherein an error detection and an error concealment are involved in the decompression.

These and other objectives of the present invention will no doubt become obvious to those of ordinary skill in the art after reading the following detailed description of the preferred embodiment that is illustrated in the various figures and drawings.

### BRIEF DESCRIPTION OF THE DRAWINGS

FIG. 1 is a block diagram illustrating a data processing system according to an embodiment of the present invention.
FIG. 2 is a diagram illustrating a display data compression without compression-unit interleaving and a display data compression with compression-unit interleaving according to an embodiment of the present invention.
FIG. 3 is a diagram illustrating data partitioning of a compressed data of a compression unit in a frame according to an embodiment of the present invention.
FIG. 4 is a diagram illustrating a display data compression without constrained coding reference for prediction and a display data compression with constrained coding reference for prediction according to an embodiment of the present invention.
FIG. 5 is a diagram illustrating a display data compression without constrained coding reference for rate control and a display data compression with constrained coding reference for rate control according to an embodiment of the present invention.
FIG. 6 is a diagram illustrating re-synchronization marker insertion applied to the compressed display data according to an embodiment of the present invention.
FIG. 7 is a diagram illustrating error correction code insertion applied to the compressed display data according to an embodiment of the present invention.
FIG. 8 is a diagram illustrating a compressed data copy inserted to the compressed display data according to an embodiment of the present invention.
FIG. 9 is a diagram illustrating another compressed data copy inserted to the compressed display data according to an embodiment of the present invention.
FIG. 10 is a flowchart illustrating an error-robust compression method according to an embodiment of the present invention.
FIG. 11 is a diagram illustrating a first example of the processing circuit shown in FIG. 1.
FIG. 12 is a diagram illustrating a second example of the processing circuit shown in FIG. 1.
FIG. 13 is a diagram illustrating a first example of the spatial error concealment technique applied to a compression unit according to an embodiment of the present invention.
FIG. 14 is a diagram illustrating a second example of the spatial error concealment technique applied to a compression unit according to an embodiment of the present invention.
FIG. 15 is a diagram illustrating an example of the temporal error concealment technique applied to a compression unit according to an embodiment of the present invention.
FIG. 16 is a flowchart illustrating an error detection and concealment method according to an embodiment of the present invention.

### DETAILED DESCRIPTION

Certain terms are used throughout the description and following claims to refer to particular components. As one skilled in the art will appreciate, manufacturers may refer to a component by different names. This document does not intend to distinguish between components that differ in name but not function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

The concept of the present invention is to apply data compression upon display data and then transmit compressed display data over a display interface. As the data size/data rate of the compressed display data is smaller than that of the original un-compressed display data, the power consumption of the display interface is reduced correspondingly. However, bit error(s) may occur during data transmission between an encoder side (e.g., an application processor) and a decoder side (e.g., a driver IC). When data compression is applied to the display data, error pixels resulting from bit error(s) introduced during compressed data transmission will be propagated and shown on a display apparatus, where the size of an error propagation area is related to a compression unit size. To improve error robustness of the display data compression, the present invention further proposes adding at least one error-resilient coding tool to a compressor and/or configuring a de-compressor to have an error detection and error concealment capability. Further details will be described as below.

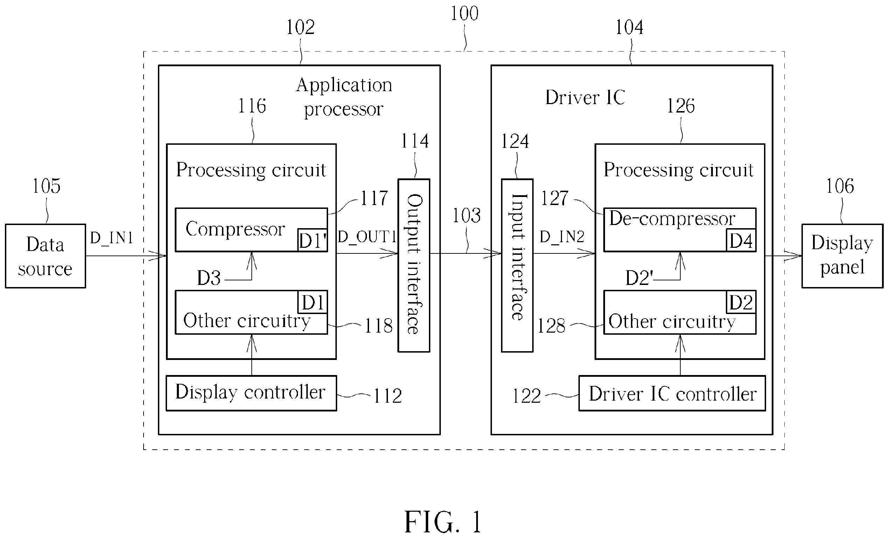

FIG. 1 is a block diagram illustrating a data processing system according to an embodiment of the present invention. The data processing system 100 includes a plurality of data processing apparatuses such as an application processor 102 and a driver integrated circuit (IC) 104. The application processor 102 and the driver IC 104 may be implemented in different chips, and the application processor 102 communicates with the driver IC 104 via a display interface 103. In this embodiment, the display interface 103 may be a display serial interface (DSI) standardized by a Mobile Industry Processor Interface (MIPI) or an embedded display port (eDP) standardized by a Video Electronics Standards Association (VESA).

The application processor 102 is coupled to the display interface 103, and supports un-compressed data transmission and compressed data transmission. When the application processor 102 is used to transmit un-compressed data to the driver IC 104, the application processor 102 generates an output display data D OUT1 according to a source display data D_IN1 provided by an external data source 105, where the output display data D OUT1 is derived from un-compressed display data D1, and the un-compressed display data D1 is derived from the source display data D_IN1. When the application processor 102 is used to transmit compressed data to the driver IC 104, the application processor 102 generates the output display data D_OUT1 according to the source display data D_IN1 provided by the external data source 105, where the output display data D_OUT1 is derived from compressed display data D1', the compressed display data D1' is derived from an input display data D3, and the input display data D3 is derived from the un-compressed display data D1 or the source display data D_IN1. When the application processor 102 enables one of the un-compressed data transmission and the compressed data transmission, the application processor 102 further transmits the output display data D_OUT1 over the display interface 103. By way of example, but not limitation, the data source 105 may be a camera sensor, a memory card or a wireless receiver, and the source display data D_IN1 may include image data, video data, graphic data, and/or OSD data. Further, the source display data D_IN1 may be single view data for 2D display or multiple view data for 3D display.

As shown in FIG. 1, the application processor 102 includes a display controller 112, an output interface 114 and a processing circuit 116. The processing circuit 116 includes circuit elements required for processing the source display data D_IN1 to generate the output display data D_OUT1 (which may be un-compressed data for un-compressed data transmission over the display interface 103, or may be compressed data for compressed data transmission over the display interface 103). For example, the processing circuit 116 may have a compressor 117 and other circuitry 118, where the other circuitry 118 may have a display processor, a multiplexer, additional image/video processing element(s), etc. The display processor may perform image processing operations, including scaling, rotating, etc. For example, the display processor processes display data derived from the source display data D_IN1 to generate the un-compressed display data D1, where the source display data D_IN1 may be bypassed or processed by the additional image/video processing element(s) located before the display processor.

The compressor 117 is configured to perform display data compression. Hence, the compressor 117 performs compression upon the input display data D3 to generate the compressed display data D1'. In one exemplary design, the input display data D3 may be the source display data D_IN1 provided by the data source 105. In another exemplary design, the input display data D3 may be the un-compressed display data D1 provided by the other circuitry 118.

The multiplexer of the other circuitry 118 receives the un-compressed display data D1 and the compressed display data D1', and selectively outputs the un-compressed display data D1 or the compressed display data D1' according to the operation mode of the application processor 102. For example, the display controller 112 controls the operation of the application processor 102. Hence, when the application processor 102 is operated under a compression mode, the multiplexer is controlled by the display controller 112 to output the compressed display data D1' to be the output display data D_OUT1; and when the application processor 102 is operated under a non-compression mode, the multiplexer is controlled by the display controller 112 to output the un-compressed display data D1 to be the output display data D_OUT1. As the present invention focuses on the error-robust display data compression, further description of the other circuit 118 is omitted here for brevity. The output interface 114 is arranged for packing/packetizing the output display data D_OUT1 into an output bitstream according to the transmission protocol of the display interface 103, and transmits the output bitstream to the driver IC 104 via the display interface 103.

Concerning the error-robust display data compression, at least one error-resilient coding tool is involved in the compression performed by the compressor 117. For example, the compressor 117 may employ at least one of the proposed error-resilient coding tools, including compression-unit interleaving, data partitioning, constrained coding reference and redundancy information insertion, to achieve the error-robust display data compression. Further details of the proposed error-resilient coding tools are described as below.

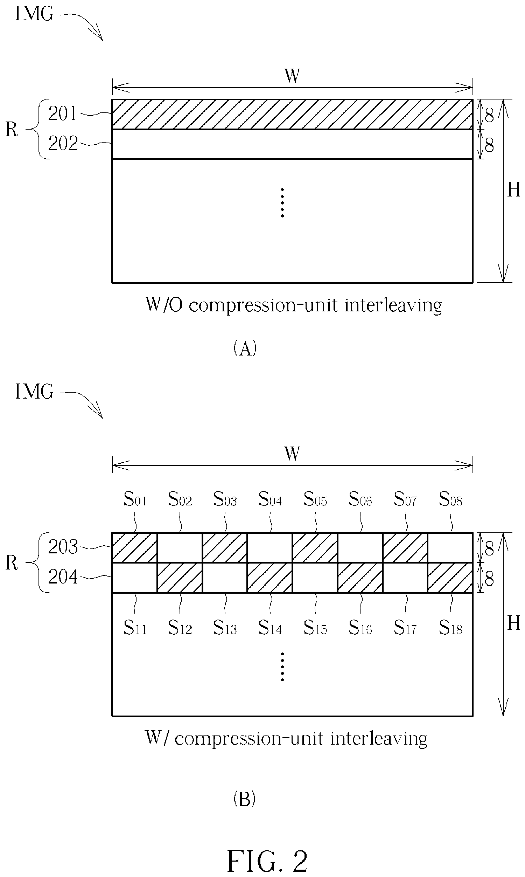

FIG. 2 is a diagram illustrating a display data compression without compression-unit interleaving and a display data compression with compression-unit interleaving according to an embodiment of the present invention. The input display data D3 fed into the compressor 117 includes a display data of a frame IMG. The size of the frame IMG is WxH. That is, the number of pixel columns in the frame IMG is W, and the number of pixel rows in the frame IMG is H. A compression unit is a minimum encoding segment that can be independently decoded. For example, the size of each compression unit is Wx8. The sub-diagram (A) of FIG. 2 illustrates the display data compression without compression-unit interleaving. A region R in the frame IMG is divided into two compression units 201 and 202, each having 8 consecutive pixel rows. Consider a case where bit errors are introduced to the compressed data of a specific compression unit during compressed data transmission over the display interface 103. When the compressed data with error bits is decoded at the driver IC 104, error propagation may occur in a continuous display area corresponding to the corrupted specific compression unit.

To mitigate the image quality degradation caused by the error propagation, the compressor 117 can be configured to perform the display data compression with compression-unit interleaving, as illustrated in sub-diagram (B) of FIG. 2. The compressor 117 uses compression-unit interleaving as one error-resilient coding tool. Hence, the compressor 117 partitions the region R in the frame IMG into a plurality of sub-regions S01-S08 and S11-S18. In this example, the size of each sub-region is 8x8. The compressor 117 selects interleaved sub-regions from the sub-regions S01-S08 and S11-S18 in the region R of the frame IMG to form one compression unit with the size of Wx8. Hence, one compression unit 203 is composed of sub-regions S01, S12, S03, S14, S05, S16, S07, and S18; and another compression unit 204 is composed of sub-regions S11, S02, S13, S04, S15, S06, S17, and S08. Consider a case where bit errors are introduced to the compressed data of a specific compression unit during compressed data transmission over the display interface 103. When the compressed data with error bits is decoded at the driver IC 104, error propagation is constrained in a discontinuous display area corresponding to the corrupted specific compression unit composed of interleaved sub-regions.

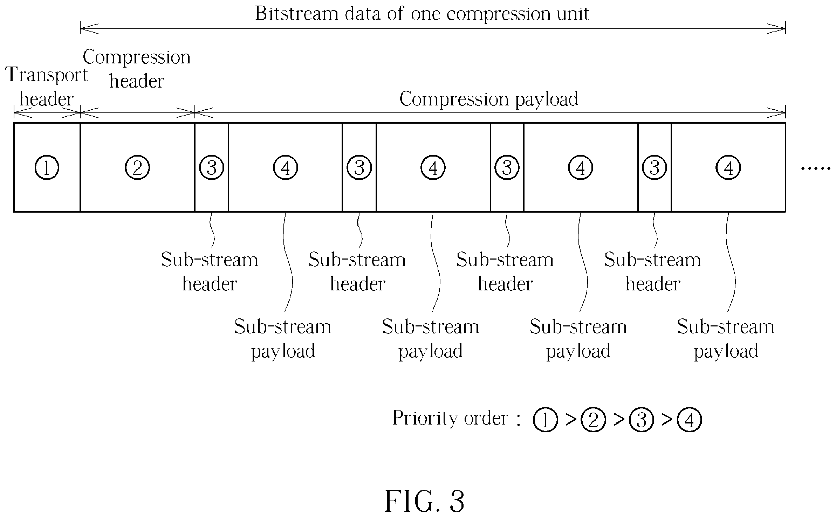

FIG. 3 is a diagram illustrating data partitioning of a compressed data of a compression unit in a frame according to an embodiment of the present invention. For example, a compression unit shown in sub-diagram (A) of FIG. 2 is compressed by the compressor 117 using data partitioning as one error-resilient coding tool. The compressor 117 is configured to partition and organize the compressed data of the compression unit into a plurality of data segments. The compressed data of the compression unit may have two parts, including a compression header and a compression payload. The data segments obtained by the data partitioning may include the compression header, sub-stream headers of the compression payload, and sub-stream payloads of the compression payload. For example, the compression header of the compression unit may include a picture parameter set (PPS) in VESA's display stream compression. A sub-stream header may include a parameter K in Golomb-Rice coding. A sub-stream payload may include prefix and suffix parts in Golomb-Rice coding. In addition, the output interface 114 may add a transport header when packing the compressed display data D1' into the output bitstream.

The data segments derived from partitioning and organizing the compressed data of the compression unit may include at least a first data segment with a first priority and a second data segment with a second priority. The compressor 117 configures error detection and correction capability of the first data segment and the second data segment based on the priority order of the first priority and the second priority. For example, the priority of the transport header of the output bitstream is higher than the priority of the compression header of the compression unit, the priority of the compression header of the compression unit is higher than the priority of the sub-stream header in the compression payload of the compression unit, and the priority of the sub-stream header in the compression payload of the compression unit is higher than the priority of the sub-stream payload in the compression payload of the compression unit. The compressor 117 configures an error correction code or a cyclic redundancy check (CRC) checksum to improve the error resilience, where the error detection and correction capability depends on the priority order. For example, the compressor 117 generates an error correction code for a data segment with a higher priority, but does not generate an error correction code for a data segment with a lower priority. For another example, the compressor 117 generates an error correction code with stronger error detection and correction capability for a data segment with a higher priority, and generates an error correction code with weaker error detection and correction capability for a data segment with a lower priority. However, these are for illustrative purposes only, and are not meant to be limitations of the present invention.

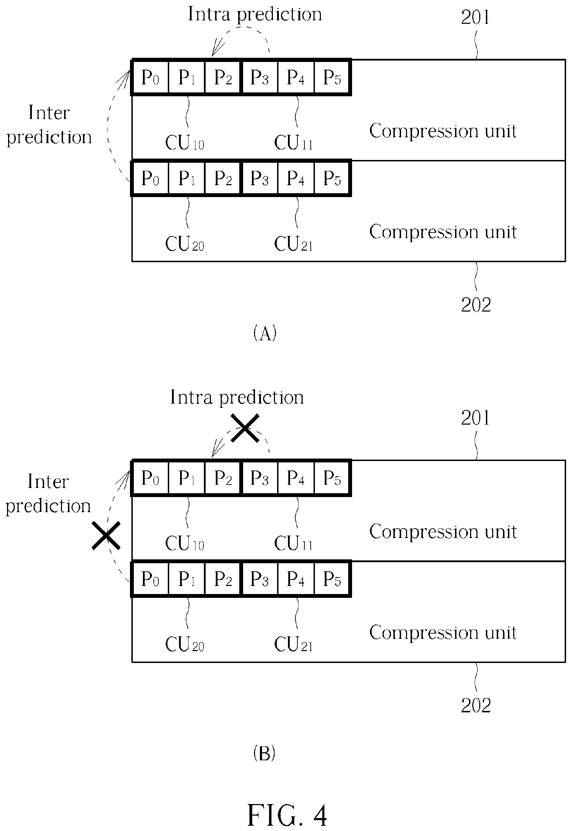

FIG. 4 is a diagram illustrating a display data compression without constrained coding reference for prediction and a display data compression with constrained coding reference for prediction according to an embodiment of the present invention. As mentioned above, a compression unit is a minimum encoding segment that can be independently decoded. In addition, one compression unit may be composed of a plurality of coding units each having a plurality of pixels. For example, each of the compression units 201 and 202 shown in sub-diagram (A) of FIG. 2 includes a plurality of coding units each having three pixels. As illustrated in sub-diagram (A) of FIG. 4, one coding unit CU10 in the compression unit 201 is composed of pixels P0, P1, and P2 of the compression unit 201; and another coding unit CU11 in the compression unit 201 is composed of pixels P3, P4, and P5 of the compression unit 201. Further, one coding unit CU20 in the compression unit 202 is composed of pixels P0, P1, and P2 of the compression unit 202; and another coding unit CU21 in the compression unit 202 is composed of pixels P3, P4, and P5 of the compression unit 202. When there is no constrained coding reference for prediction as illustrated in sub-diagram (A) of FIG. 4, encoding of the coding unit CU11 in the compression unit 201 may employ an intra compression-unit prediction provided by the pixel data of the coding unit CU10 in the same compression unit 201, and/or encoding of the coding unit CU20 in the compression unit 202 may employ an inter compression-unit prediction provided by the pixel data of the coding unit CU10 in the compression unit 201. Consider a case where bit errors are introduced to the compressed data of the compression unit 201 (particularly, the compressed data of the coding unit CU10) during compressed data transmission over the display interface 103. When the compressed data with error bits is decoded at the driver IC 104, error propagation may occur in a continuous display area corresponding to the compression unit 201 (or both compression units 201 and 202) due to prediction dependency.

To mitigate the image quality degradation caused by the error propagation, the compressor 117 can be configured to perform the display data compression with constrained coding reference for prediction, as illustrated in sub-diagram (B) of FIG. 4. Hence, the compressor 117 blocks an intra compression-unit prediction provided by the coding unit CU10 in the compression unit 201 from being used for encoding the coding unit CU11 in the same compression unit 201, and/or blocks an inter compression-unit prediction provided by the coding unit CU10 in the compression unit 201 from being used for encoding the coding unit CU20 in the different compression unit 202.

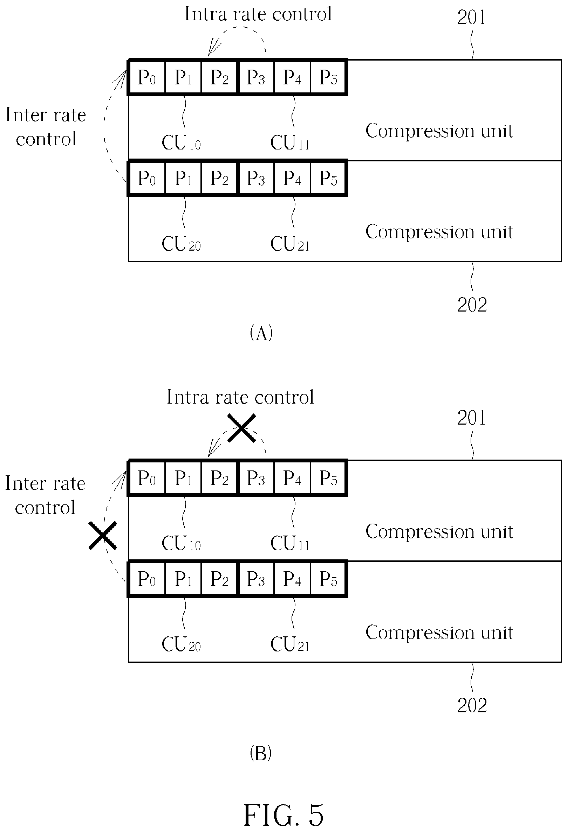

FIG. 5 is a diagram illustrating a display data compression without constrained coding reference for rate control and a display data compression with constrained coding reference for rate control according to an embodiment of the present invention. As mentioned above, a compression unit is a minimum encoding segment that can be independently decoded; in addition, one compression unit may be composed of a plurality of coding units each having a plurality of pixels. By way of example, but not limitation, each compression unit in the same frame may be assigned the same target bit budget. When there is no constrained coding reference for rate control as illustrated in sub-diagram (A) of FIG. 5, a bit budget allocated to one coding unit may be dynamically adjusted by an intra compression-unit rate control or an inter compression-unit rate control. For example, a bit budget allocated to the coding unit CU11 in the compression unit 201 may be set based at least partly on a remaining bit budget left from encoding of the coding unit CU10 in the same compression unit 201, and/or a bit budget allocated to the coding unit CU20 in the compression unit 202 may be set based at least partly on a remaining bit budget left from encoding of the coding unit CU10 in the compression unit 201. Consider a case where bit errors are introduced to the compressed data of the compression unit 201 (particularly, the compressed data of the coding unit CU10) during compressed data transmission over the display interface 103. When the compressed data with error bits is decoded at the driver IC 104, error propagation may occur in a continuous display area of the compression unit 201 (or both compression units 201 and 202) due to rate control dependency.

To mitigate the image quality degradation caused by the error propagation, the compressor 117 can be configured to perform the display data compression with constrained coding reference for rate control, as illustrated in sub-diagram (B) of FIG. 5. Hence, the compressor 117 blocks a remaining bit budget left from encoding of the coding unit CU10 in the compression unit 201 from being used for configuring a bit budget allocated to the coding unit CU11 in the same compression unit 201, and/or blocks a remaining bit budget left from encoding of the coding unit CU10 in the compression unit 201 from being used for configuring a bit budget allocated to the coding unit CU20 in the different compression unit 202.

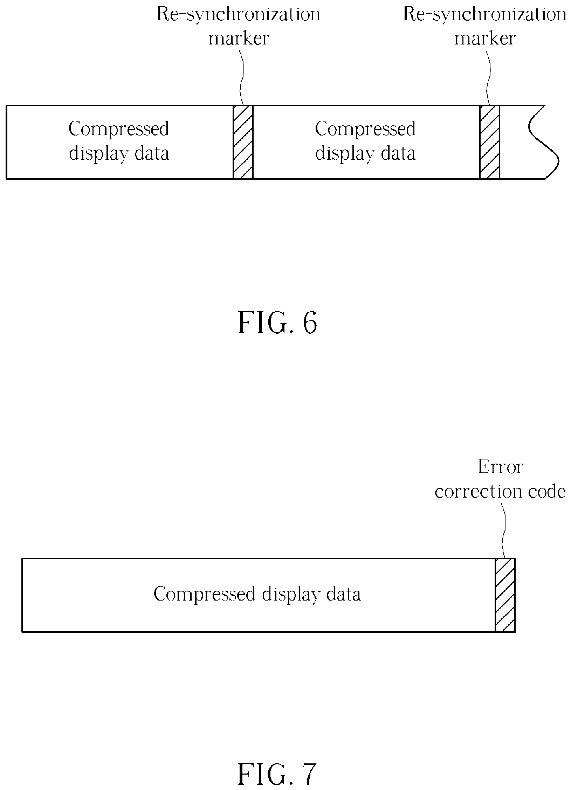

When the error-resilient coding tool involved in the compression is the redundant information insertion, the redundant information may include a re-synchronization marker, an error correction code, and/or a copy of at least a portion of the compressed display data. FIG. 6 is a diagram illustrating re-synchronization marker insertion applied to the compressed display data according to an embodiment of the present invention. As mentioned above, the compression output of one compression unit in a frame may include a compression header and a compression payload. It should be noted that the re-synchronization marker may be a unique codeword different from all possible payload codewords and all possible header syntax patterns that may be transmitted over the display interface 103. In other words, the re-synchronization marker is uniquely identifiable in the compressed display data D1' generated from compressing the input display data D3. The bit errors will not be propagated when encountering re-synchronization markers inserted in the compressed display data. For example, when a decoder side (e.g., driver IC 104) detects an error in the bitstream received from the display interface 103, it may discard bits until a re-synchronization marker is detected. When re-synchronization markers are inserted at proper locations, errors will be localized to small spatial regions in a frame.

FIG. 7 is a diagram illustrating error correction code insertion applied to the compressed display data according to an embodiment of the present invention. The compressor 117 calculates at least one error correction code (e.g., at least one CRC checksum) according to the compressed display data D1', and adds the at least one error correction code (e.g., at least one CRC checksum) to the compressed display data D1'. In the example shown in FIG. 7, one error correction code (e.g., one CRC checksum) is inserted after the compressed display data D1', thereby improving the error detection and correction capability in the decoder side (e.g., driver IC 104).

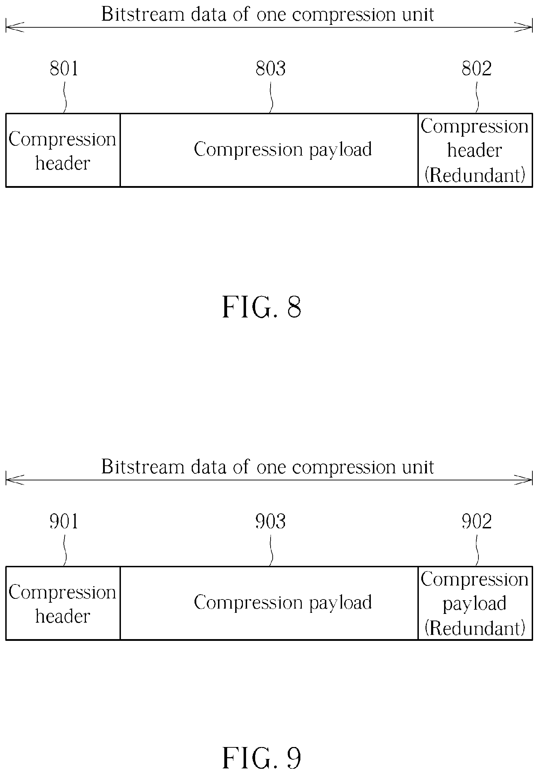

FIG. 8 is a diagram illustrating a compressed data copy inserted to the compressed display data according to an embodiment of the present invention. The compressor 117 generates at least one copy of at least a portion (i.e., part or all) of the compressed display data D1' to the output interface 114 for transmission. As mentioned above, the compression output of one compression unit in a frame may include a compression header 801 and a compression payload 803. In the example shown in FIG. 8, the compressor 117 copies the compression header 801 to generate a redundant compression header 802 to the output interface 114, such that the bitstream data of one compression unit will have two compression headers 801 and 802. When one compression header (e.g., 801) is corrupted during the compressed data transmission over the display interface 103, the other compression header (e.g., 802) can be used in the decoder side (e.g., driver IC 104).

FIG. 9 is a diagram illustrating another compressed data copy inserted to the compressed display data according to an embodiment of the present invention. The compressor 117 generates at least one copy of at least a portion (i.e., part or all) of the compressed display data D1' to the output interface 114 for transmission. As mentioned above, the compression output of one compression unit in a frame may include a compression header 903 and a compression payload 901. In the example shown in FIG. 9, the compressor 117 copies a portion of the compression payload 901 to generate a redundant compression payload 902 to the output interface 114, such that the bitstream data of one compression unit will have a full compression payload 901 and a partial compression payload 902. When a portion of the full compression payload 901 is corrupted during the compressed data transmission over the display interface 103, the additional partial compression payload 902 can be used in the decoder side (e.g., driver IC 104).

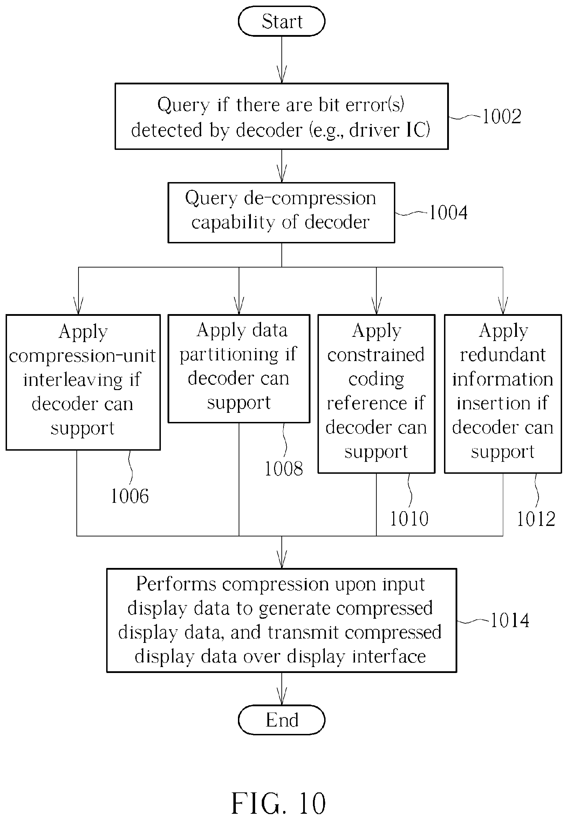

FIG. 10 is a flowchart illustrating an error-robust compression method according to an embodiment of the present invention. The error-robust compression method may be employed by the application processor 102 having the compressor 117. In step 1002, the display controller 112 of the application processor 102 queries the driver IC 104 to determine if there are bit error(s) detected by the driver IC 104. For example, the bit error(s) may occur during compressed data transmission over the display interface 103. In step 1004, the display controller 112 of the application processor 102 further queries the driver IC 104 to know the de-compression capability of the driver IC 104. When there are bit errors occurring during compressed data transmission over the display interface 103, the compressor 117 can selectively enable the error-robust compression based on the de-compression capability of the driver IC 104. When the de-compression capability of the driver IC 104 indicates that the compression-unit interleaving is supported, the compressor 117 may enable the compression-unit interleaving while performing compression upon the input display data D3 (Step 1006). When the de-compression capability of the driver IC 104 indicates that the data partitioning is supported, the compressor 117 may enable the data partitioning while performing compression upon the input display data D3 (Step 1008). When the de-compression capability of the driver IC 104 indicates that the constrained coding reference is supported, the compressor 117 may enable the constrained coding reference while performing compression upon the input display data D3 (Step 1010). When the de-compression capability of the driver IC 104 indicates that the redundant information insertion is supported, the compressor 117 may enable the redundant information insertion while performing compression upon the input display data D3 (Step 1012). In step 1014, the compressor 117 performs compression upon the input display data D3 to generate the compressed display data D1', and transmits the compressed display data D1' to the display interface 103 through the output interface 114. It should be noted that step 1002 is optional. That is, step 1002 may be omitted, depending upon actual design consideration.

Please refer to FIG. 1 again. Regarding the driver IC 104, it communicates with the application processor 102 via the display interface 103. In this embodiment, the driver IC 104 is coupled to the display interface 103, and supports un-compressed data reception and compressed data reception. When the application processor 102 transmits the output display data D_OUT1 (which is derived from the un-compressed data D1) to the driver IC 104, the driver IC 104 is operated under a non-decompression mode to obtain an un-compressed data D2 and drive a display panel 106 according to the un-compressed display data D2. By way of example, the display panel 106 may be implemented using any 2D/3D display device. When the application processor 102 transmits the output display data D OUT1 (which is derived from the compressed data D1') to the driver IC 104, the driver IC 104 is operated under a de-compression mode to obtain a de-compressed display data D4 and drive the display panel 106 according to the de-compressed display data D4.

As shown in FIG. 1, the driver IC 104 includes a driver IC controller 122, an input interface 124 and a processing circuit 126. The input interface 124 is arranged for receiving an input bitstream from the display interface 103, and un-packing/un-packetizing the input bitstream into an input display data D IN2 according to the transmission protocol of the display interface 103. The processing circuit 126 may include circuit elements required for driving the display panel 106 according to a video mode or an image/command mode. For example, the processing circuit 126 may have a de-compressor 127 and other circuitry 128, and the other circuitry 128 may have a display buffer, multiplexers, etc. The de-compressor 127 is used for performing de-compression upon a compressed display data D2' derived from the input display data D_IN2. The display buffer is arranged for storing a display data to provide a buffered display data under the image/command mode, wherein the display data stored into the display buffer may be an un-compressed display data, a compressed display data or a de-compressed display data, depending upon actual design consideration/requirement. The multiplexers control interconnections of the de-compressor 127, the display buffer and the display panel 106. As the present invention focuses on the error detection and error concealment performed by the de-compressor 127, further description of the other circuitry 128 is omitted here for brevity.

The de-compressor 127 performs decompression upon the compressed display data D2' derived from the input display data D_IN2 to generate the de-compressed display data D4, where an error detection and an error concealment are involved in the decompression. The de-compressor 127 may detect bit error(s) in the compressed display data D2' through a bitstream-level detection, or detect bit error(s) in the de-compressed display data D4 through a pixel-level detection.

In one exemplary design of the bitstream-level detection, the de-compressor 127 detects error(s) in the compressed display data D2' by checking at least one error correction code (e.g., at least one CRC checksum) of the compressed display data D2'. For example, as shown in FIG. 7, an error correction code at the end of a compressed display data transmitted from the application processor 102 to the driver IC 104 may be used by the de-compressor 127 to verify correctness of the received compressed display data. In another exemplary design of the bitstream-level detection, the de-compressor 127 detects error(s) in the compressed display data D2' by checking occurrence of any illegal syntax (e.g., illegal codeword) in the compressed display data D2'.

Concerning the pixel-level detection, the de-compressor 127 detects error(s) in the de-compressed display data D4 by checking smoothness of at least one boundary, wherein the at least one boundary is between two de-compressed compression units, or is between two de-compressed coding units in the same compression unit. When a compressed compression unit (or a compressed coding unit) has bit error(s), the error propagation will degrade the image quality of a corresponding de-compressed compression unit (or de-compressed coding unit). The boundary between a corrupted compression unit (or corrupted coding unit) and a neighboring compression unit (or neighboring coding unit) will have unnatural image characteristics. Hence, when a smoothness level at a boundary between two de-compressed compression units (or two de-compressed coding units in the same compression unit) is lower than a threshold, the de-compressor 127 may determine that at least one of the de-compressed compression units (or de-compressed coding units) has error(s). When the smoothness level at the boundary between two de-compressed compression units (or two de-compressed coding units in the same compression unit) is not lower than the threshold, the de-compressor 127 may determine that both of the de-compressed compression units (or de-compressed coding units) are error-free.

After the error detection performed by the de-compressor 127 detects occurrence of error(s), the de-compressor 127 is operative to perform an error concealment operation to conceal corrupted de-compressed compression units to avoid image quality degradation.

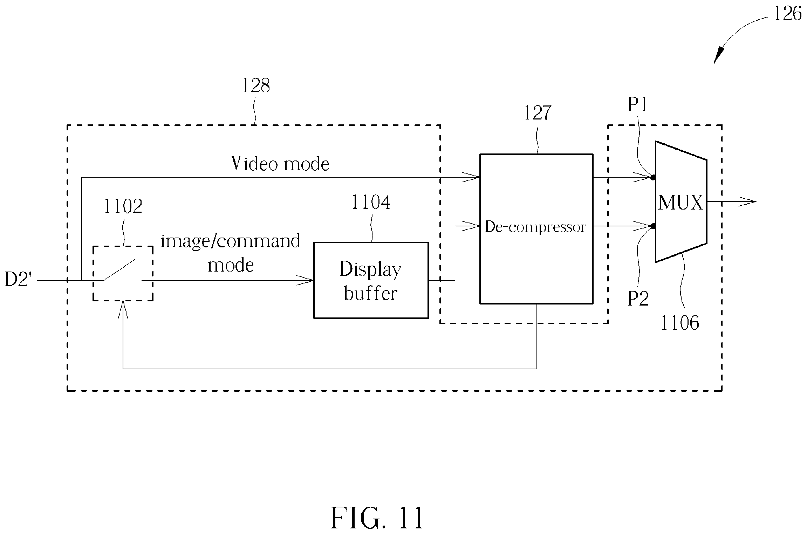

FIG. 11 is a diagram illustrating a first example of the processing circuit 126 shown in FIG. 1. In this example, the other circuitry 128 may have a switch 1102, a display buffer 1104, and a multiplexer (MUX) 1106. When the driver IC 104 is operated in the video mode for driving the display panel 106, the compressed display data D2' is not stored into the display buffer 1104, and is directly de-compressed by the de-compressor 127 to generate the de-compressed display data D4 to a first input port P1 of the MUX 1106, and the MUX 1106 outputs the de-compressed display data D4 received at the first input port P1 to the display panel 106.

When the driver IC 104 is operated in the image/command mode to drive the display panel 106, the compressed display data D2' is stored into the display buffer 1104, the de-compressor 127 de-compresses the compressed display data D2' read from the display buffer 1104 to generate the de-compressed display data D4 to a second input port P2 of the MUX 1106, and the MUX 1106 outputs the de-compressed display data D4 received at the second input port P2 to the display panel 106. In addition, the switch 1102 is controlled by the error detection performed by the de-compressor 127. For example, when the de-compressor 127 detects error(s) during processing of a current frame, the de-compressor 127 may control the switch 1102 to disconnect the display buffer 1104 from a compressed data input, such that the remaining compressed data of the current frame is not stored into the display buffer 1104. When the compressed data of a next frame (e.g., re-transmitted compressed data of the current frame) is available at the compressed data input, the de-compressor 127 may control the switch 1102 to connect the display buffer 1104 to the compressed data input, thereby allowing the compressed data of the next frame (e.g., re-transmitted compressed data of the current frame) to overwrite data of the corrupted frame in the display buffer 1104. However, this is for illustrative purposes only, and is not meant to be a limitation of the present invention. The switch 1102 shown in FIG. 11 may be omitted, depending upon actual design consideration.

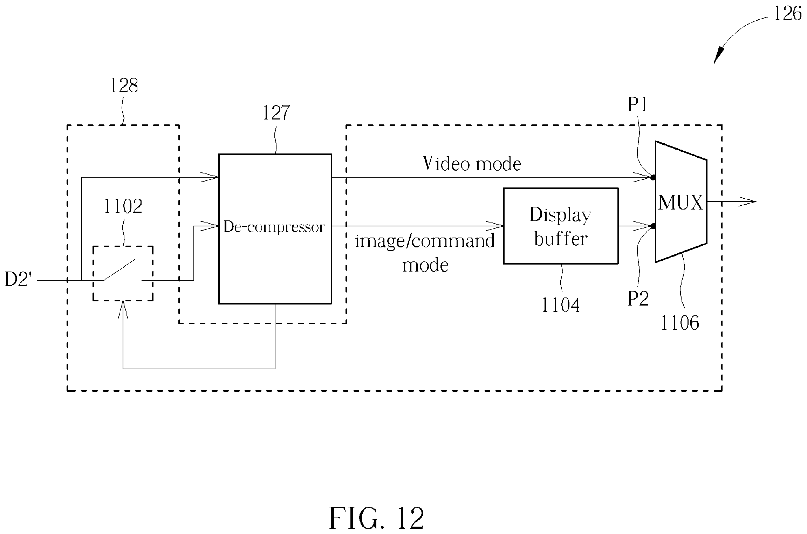

FIG. 12 is a diagram illustrating a second example of the processing circuit 126 shown in FIG. 1. The major difference between the example shown in FIG. 11 and the example shown in FIG. 12 is the location of the display buffer 1104. In the example shown in FIG. 12, the display buffer 1104 may serve as a frame buffer to store the de-compressed display data D4 generated from the de-compressor 127 in the image/command mode. Specifically, when the driver IC 104 is operated in the image/command mode to drive the display panel 106, the compressed display data D2' is fed into the de-compressor 127, the de-compressor 127 generates the de-compressed display data D4 to the display buffer 1104, and the MUX 1106 outputs the de-compressed display data D4 read from the display buffer 1104 to the display panel 106. In addition, the switch 1102 is controlled by the error detection performed by the de-compressor 127. For example, when the de-compressor 127 detects error(s) during processing of a current frame, the de-compressor 127 may control the switch 1102 to disconnect the de-compressor 127 from a compressed data input, such that the remaining compressed data of the current frame is not transmitted to the de-compressor 127. When the compressed data of a next frame (e.g., re-transmitted compressed data of the current frame) is available at the compressed data input, the de-compressor 127 may control the switch 1102 to connect the de-compressor 127 to the compressed data input, thereby allowing the compressed data of the next frame (e.g., re-transmitted compressed data of the current frame) to be fed into the de-compressor 127. However, this is for illustrative purposes only, and is not meant to be a limitation of the present invention. The switch 1102 shown in FIG. 12 may be omitted, depending upon actual design consideration.

Regarding the examples shown in FIG. 11 and FIG. 12, the de-compression 127 may be configured to employ a spatial error concealment technique or a temporal error concealment technique to conceal a corrupted de-compressed compression unit to avoid image quality degradation. Further details of the spatial error concealment technique and the temporal error concealment technique applied to a compression unit are described as below.

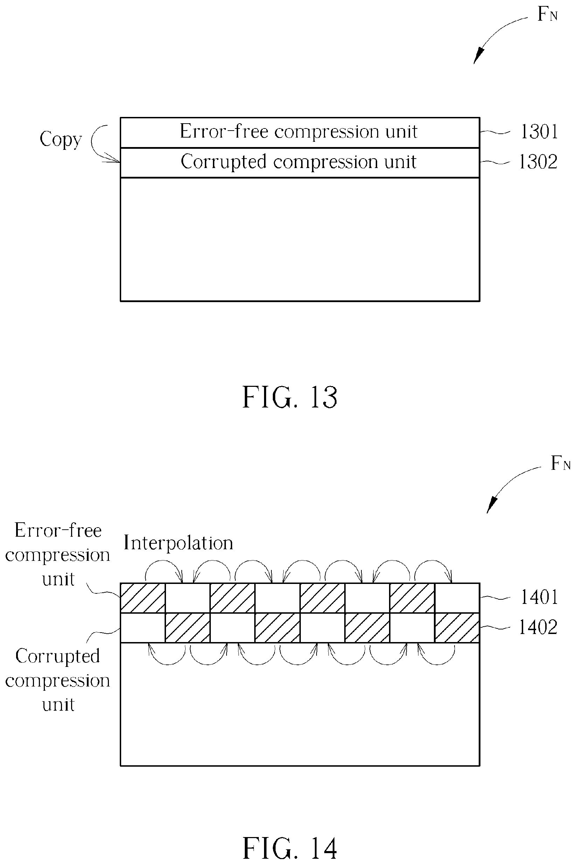

FIG. 13 is a diagram illustrating a first example of the spatial error concealment technique applied to a compression unit according to an embodiment of the present invention. One frame FN has a plurality of compression units (e.g., 1301 and 1302) included therein. In this example, the error detection performed by the de-compressor 127 indicates that the compression unit 1301 is error-free, and further indicates that the compression unit 1302 is corrupted due to bit error(s) detected. The spatial error concealment employed by the de-compressor 127 conceals the corrupted compression unit 1302 by a spatially-neighboring error-free compression unit (e.g., error-free compression unit 1301) in the same frame FN.

FIG. 14 is a diagram illustrating a second example of the spatial error concealment technique applied to a compression unit according to an embodiment of the present invention. One frame FN has a plurality of compression units (e.g., 1401 and 1402) included therein. In this example, compression-unit interleaving is employed by the compressor 117 at the application processor 102. Hence, each of the compression units 1401 and 1402 is composed of interleaved sub-regions. The error detection performed by the de-compressor 127 indicates that the compression unit 1401 is error-free, and further indicates that the compression unit 1402 is corrupted due to bit error(s) detected. The spatial error concealment employed by the de-compressor 127 conceals the corrupted compression unit 1402 by an interpolated compression unit, wherein the interpolated compression unit is derived from interpolating one or more spatially-neighboring error-free compression units in the same frame FN. For example, the interpolated compression unit is generated by interpolating interleaved sub-regions included in the error-free compression unit 1401.

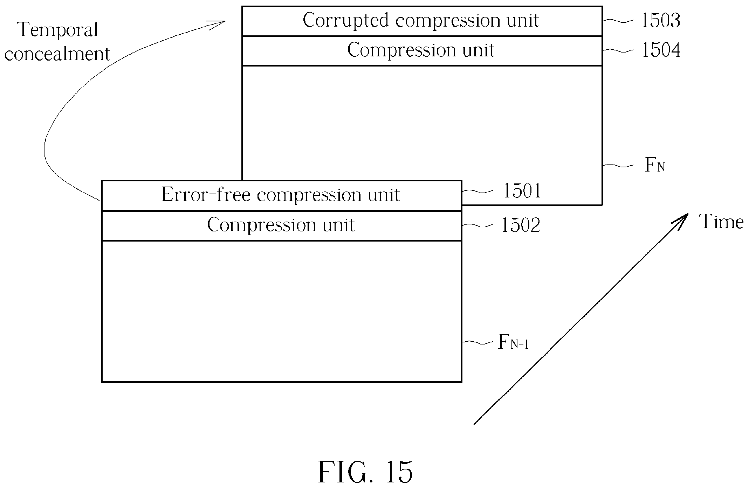

FIG. 15 is a diagram illustrating an example of the temporal error concealment technique applied to a compression unit according to an embodiment of the present invention. There are successive frames (e.g., FN-1 and FN) in the time domain, where the frame FN-1 has a plurality of compression units (e.g., 1501 and 1502) included therein, and the frame FN has a plurality of compression units (e.g., 1503 and 1504) included therein. It should be noted that the compression units 1501 and 1503 are co-located in different frames FN-1 and FN, and the compression units 1502 and 1504 are co-located in different frames FN-1 and FN. In this example, the error detection performed by the de-compressor 127 indicates that the compression unit 1501 in the previous frame FN-1 is error-free, and further indicates that the compression unit 1503 in the current frame FN is corrupted due to bit error(s) detected. The temporal error concealment employed by the de-compressor 127 conceals the corrupted compression unit 1503 in the current frame FN by a temporally-neighboring error-free compression unit (e.g., the co-located error-free compression unit 1501) in the previous frame FN-1.

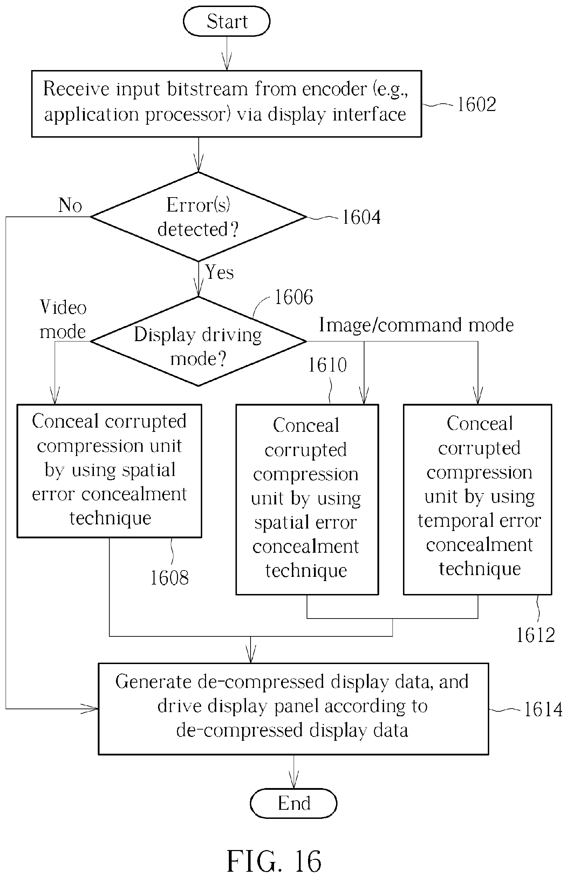

FIG. 16 is a flowchart illustrating an error detection and concealment method according to an embodiment of the present invention. The error detection and concealment method may be employed by the driver IC 104 having the de-compressor 127. In step 1602, the driver IC 104 receives an input bitstream from the display interface 103. In step 1604, the de-compressor 127 performs the error detection to check if there are error(s) detected in the compressed display data D2'/de-compressed display data D4. If there is no error detected, the flow proceeds with step 1614. However, if there are error(s) detected, the flow proceeds with step 1606. In step 1606, a display driving mode of the driver IC 104 is checked. If the driver IC 104 is operated in a video mode to drive the display panel 106, the flow proceeds with step 1608. If the driver IC 104 is operated in an image/command mode to drive the display panel 106, the flow proceeds with one of steps 1610 and 1612. In each of steps 1608 and 1610, the de-compressor 127 employs a spatial error concealment technique to conceal any corrupted de-compressed compression unit. In one exemplary design, the de-compressor 127 has a line buffer. Hence, the de-compressor 127 can use the line buffer to achieve spatial error concealment under the video mode. In addition, the de-compressor 127 can use the display buffer to achieve spatial error concealment under the image/command mode. In step 1612, the de-compressor 127 employs a temporal error concealment technique to conceal any corrupted de-compressed compression unit. In one exemplary design, the de-compressor 127 can use the display buffer to achieve temporal error concealment under the image/command mode. In step 1614, the de-compressor 127 generates the de-compressed display data D4 to the display panel 106. Hence, the driver IC 104 drives the display panel 106 according to the de-compressed display data D4.

Those skilled in the art will readily observe that numerous modifications and alterations of the device and method may be made while retaining the teachings of the invention. Accordingly, the above disclosure should be construed as limited only by the scope of the appended claims.

## Claims

1. A data processing apparatus (102) comprising:
a compressor (117), arranged to perform compression upon an input display data (D3) to generate a compressed display data (D1'); and
an output interface (114), arranged to pack an output display data (D_OUT1) derived from the compressed display data (D1') into an output bitstream, and output the output bitstream via a display interface (103),
**characterized in that**:
an error-resilient coding tool is involved in the compression;
the display interface (103) is one of a display serial interface, DSI, standardized by a Mobile Industry Processor Interface, MIPI, and an embedded display port, eDP, standardized by a Video Electronics Standards Association, VESA; and
the compressed display data (D1') comprises a compression data of a compression unit (203, 204) in a frame (IMG), and the error-resilient coding tool comprises:
partitioning and organizing the compressed data of the compression unit (203, 204) into a plurality of data segments, wherein the data segments include at least a first data segment with a first priority and a second data segment with a second priority; and
configuring error detection and correction capability of the first data segment and the second data segment based on a priority order of the first priority and the second priority.

2. The data processing apparatus of claim 1, wherein the input display data (D3) comprises a display data of a frame (IMG), and the error-resilient coding tool comprises:
partitioning a region (R) in the frame (IMG) into a plurality of sub-regions (S01-S08, S11-S18); and
selecting interleaved sub-regions (S01, S12, S03, S14, S05, S16, S07 and S18; S11, S02, S13, S04, S15, S06, S17 and S08) from the sub-regions (S01-S08, S11-S18) to form one compression unit (203, 204).

3. The data processing apparatus (102) of claim 1, wherein the input display data (D3) comprises a display data of a frame (IMG), and the error-resilient coding tool comprises:
blocking an intra compression-unit prediction provided by a first coding unit in a compression unit (201, 202) of the frame from being used for encoding a second coding unit in the compression unit, wherein the second coding unit is different from the first coding unit; or
blocking an inter compression-unit prediction provided by a coding unit in a first compression unit (201) of the frame from being used for encoding a coding unit in a second compression unit (202) of the frame, wherein the first compression unit (201) is different from the second compression unit (202); or
blocking a remaining bit budget left from encoding of a first coding unit in a compression unit (201, 202) of the frame from being used for configuring a bit budget allocated to a second coding unit in the compression unit (201, 202), wherein the second coding unit is different from the first coding unit; or
blocking a remaining bit budget left from encoding of a coding unit in a first compression unit (201) of the frame from being used for configuring a bit budget allocated to a coding unit in a second compression unit (202) of the frame, wherein the first compression unit (201) is different from the second compression unit (202).

4. The data processing apparatus (102) of claim 1, wherein the error-resilient coding tool comprises:
inserting at least one re-synchronization marker into the compressed display data (D1'), wherein the at least one re-synchronization marker is uniquely identifiable in the compressed display data (D1').

5. The data processing apparatus (102) of claim 1, wherein the error-resilient coding tool comprises:
calculating at least one error correction code according to the compressed display data (D1'); and
adding the at least one error correction code to the compressed display data (D1').

6. The data processing apparatus (102) of claim 1, wherein the error-resilient coding tool comprises:
generating a copy of at least a portion of the compressed display data (D1') to the output interface (114).

7. A data processing apparatus (104) comprising:
an input interface (124), arranged to receive an input bitstream from a display interface (103), and un-pack the input bitstream into an input display data (D_IN2); and
a de-compressor (127), arranged to perform decompression upon a compressed display data (D2') derived from the input display data (D_IN2) to generate a de-compressed display data (D4),
**characterized in that**:
the display interface (103) is one of a display serial interface, DSI, standardized by a Mobile Industry Processor Interface, MIPI, and an embedded display port, eDP, standardized by a Video Electronics Standards Association, VESA;
an error detection and an error concealment are involved in the decompression; and
the compressed display data comprises a compression data of a compression unit (203, 204) in a frame (IMG), the compressed data of the compression unit (203, 204) include a plurality of data segments, wherein the data segments include at least a first data segment with a first priority and a second data segment with a second priority, and error detection and correction capability of the first data segment and the second data segment is configured based on a priority order of the first priority and the second priority.

8. The data processing apparatus (104) of claim 7, wherein the error detection comprises:
detecting error(s) in the compressed display data by checking at least one error correction code of the compressed display data.

9. The data processing apparatus (104) of claim 7, wherein the error detection comprises:
detecting error(s) in the compressed display data by checking occurrence of at least one illegal syntax in the compressed display data.

10. The data processing apparatus (104) of claim 7, wherein the error detection comprises:
detecting error(s) in the de-compressed display data (D4) by checking smoothness of at least one boundary, wherein the at least one boundary is between two de-compressed compression units (203, 204), or is between two de-compressed coding units in a same compression unit (203, 204).

11. The data processing apparatus (104) of claim 7, wherein the de-compressed display data (D4) comprises a de-compressed data of a frame (F_{N}), and the error concealment comprises:
concealing a first de-compressed compression unit with error(s) (1302) by a second de-compressed compression unit (1301), wherein the first de-compressed compression unit and the second de-compressed compression unit are in the frame (F_{N}); or
concealing a first de-compressed compression unit with error(s) (1402) by an interpolated compression unit (1401), wherein the interpolated compression unit is derived from interpolating at least one second de-compressed compression unit, and the first de-compressed compression unit and the at least one second de-compressed compression unit are in the frame (F_{N}).

12. The data processing apparatus (104) of claim 7, wherein the de-compressed display data (D4) comprises a de-compressed data of a first frame (F_{N-1}) and a de-compressed data of a second frame (F_{N}), and the error concealment comprises:
concealing a first de-compressed compression unit with error(s) (1503) by a second de-compressed compression unit (1501), wherein the first de-compressed compression unit is in one of the first frame (F_{N-1}) and the second frame (F_{N}), and the second de-compressed compression unit is in another of the first frame (F_{N-1}) and the second frame (F_{N}).

13. A data processing method comprising:
utilizing a compressor (117) to perform compression upon an input display data (D3) to generate a compressed display data (D1');
packing an output display data (D_OUT1) derived from the compressed display data (D1') into an output bitstream; and
outputting the output bitstream via a display interface (103),
**characterized in that**:
an error-resilient coding tool is involved in the compression;
the display interface (103) is one of a display serial interface, DSI, standardized by a Mobile Industry Processor Interface, MIPI, and an embedded display port, eDP, standardized by a Video Electronics Standards Association, VESA; and
the compressed display data (D1') comprises a compression data of a compression unit (203, 204) in a frame (IMG), and the error-resilient coding tool comprises:
partitioning and organizing the compressed data of the compression unit (203, 204) into a plurality of data segments, wherein the data segments include at least a first data segment with a first priority and a second data segment with a second priority; and
configuring error detection and correction capability of the first data segment and the second data segment based on a priority order of the first priority and the second priority.

14. A data processing method comprising:
receiving an input bitstream from a display interface (103);
un-packing the input bitstream into an input display data (D_IN2); and
utilizing a de-compressor (127) to perform decompression upon a compressed display data (D2') derived from the input display data (D_IN2) to generate a de-compressed display data (D4),
**characterized in that**:
the display interface (103) is one of a display serial interface, DSI, standardized by a Mobile Industry Processor Interface, MIPI, and an embedded display port, eDP, standardized by a Video Electronics Standards Association, VESA;
an error detection and an error concealment are involved in the decompression; and
the compressed display data comprises a compression data of a compression unit (203, 204) in a frame (IMG), the compressed data of the compression unit (203, 204) include a plurality of data segments, wherein the data segments include at least a first data segment with a first priority and a second data segment with a second priority, and error detection and correction capability of the first data segment and the second data segment is configured based on a priority order of the first priority and the second priority.

## Patentansprüche

1. Datenverarbeitungsvorrichtung (102) umfassend:
einen Komprimierer (117), der zum Durchführen einer Komprimierung basierend auf Eingangsanzeigedaten (D3) eingerichtet ist, um komprimierte Anzeigedaten (D1') zu erzeugen; und
eine Ausgangsschnittstelle (114), die zum Packen von Ausgangsanzeigedaten (D_OUT1), die von den komprimierten Anzeigedaten (D1') erhalten sind, in einen Ausgangsbitstrom und zum Ausgeben des Ausgangsbitstroms über eine Anzeigeschnittstelle (103) eingerichtet ist,
**dadurch gekennzeichnet, dass**:
ein fehlerresistentes Kodierungswerkzeug an der Komprimierung beteiligt ist;
die Anzeigeschnittstelle (103) eine durch eine mobile Industrie-Prozessorschnittstelle, MIPI, standardisierte serielle Anzeigeschnittstelle, DSI, oder ein durch eine Vereinigung für Videoelektronik-Standards, VESA, standardisierter eingebetteter Anzeigeport, eDP, ist; und
die komprimierten Anzeigedaten (D1') Komprimierungsdaten einer Komprimierungseinheit (203, 204) in einem Bild (IMG) umfassen, und das fehlerresistente Kodierungswerkzeug umfasst:
Partitionieren und Organisieren der komprimierten Daten der Komprimierungseinheit (203, 204) in eine Mehrzahl von Datensegmenten, wobei die Datensegmente mindestens ein erstes Datensegment mit einer ersten Priorität und ein zweites Datensegment mit einer zweiten Priorität umfassen; und
Konfigurieren der Fehlererkennungsfähigkeit und der Fehlerkorrekturfähigkeit des ersten Datensegments und des zweiten Datensegments basierend auf einer Prioritätsreihenfolge der ersten Priorität und der zweiten Priorität.

2. Datenverarbeitungsvorrichtung nach Anspruch 1, wobei die Eingangsanzeigedaten (D3) Anzeigedaten eines Bildes (IMG) umfassen, und das fehlerresistente Kodierungswerkzeug umfasst:
Partitionieren eines Bereichs (R) in dem Bild (IMG) in eine Mehrzahl von Unterbereichen (S01-S08, S11-S18); und
Auswählen verschachtelter Unterregionen (S01, S12, S03, S14, S05, S16, S07 und S18; S11, S02, S13, S04, S15, S06, S17 und S08) aus den Unterregionen (S01-S08, S11- S18) zum Bilden einer Komprimierungseinheit (203, 204).

3. Datenverarbeitungsvorrichtung (102) nach Anspruch 1, wobei die Eingangsanzeigedaten (D3) Anzeigedaten eines Bildes (IMG) umfassen, und das fehlerresistente Kodierungswerkzeug umfasst:
Blockieren einer Intra-Komprimierungseinheit-Vorhersage, die von einer ersten Kodierungseinheit in einer Komprimierungseinheit (201, 202) des Bildes bereitgestellt ist, sodass die Intra-Komprimierungseinheit-Vorhersage nicht zum Kodieren einer zweiten Kodierungseinheit in der Komprimierungseinheit verwendet wird, wobei sich die zweite Kodierungseinheit von der ersten Kodierungseinheit unterscheidet; oder
Blockieren einer Inter-Komprimierungseinheit-Vorhersage, die von einer Kodierungseinheit in einer ersten Komprimierungseinheit (201) des Bildes bereitgestellt ist, sodass die Inter-Komprimierungseinheit-Vorhersage nicht zum Kodieren einer Kodierungseinheit in der zweiten Komprimierungseinheit (202) des Bildes verwendet wird, wobei sich die erste Komprimierungseinheit (201) von der zweiten Komprimierungseinheit (202) unterscheidet; oder
Blockieren eines verbleibenden Bitbudgets, das von der Kodierung einer ersten Kodierungseinheit in einer Komprimierungseinheit (201, 202) des Bildes übrigbleibt, sodass das verbleibende Bitbudget nicht zum Konfigurieren eines einer zweiten Kodierungseinheit in der Komprimierungseinheit (201, 202) zugeordneten Bitbudgets verwendet wird, wobei sich die zweite Kodierungseinheit von der ersten Kodierungseinheit unterscheidet; oder
Blockieren eines verbleibenden Bitbudgets, das von der Kodierung einer Kodierungseinheit in einer ersten Komprimierungseinheit (201) des Bildes übrigbleibt, sodass das verbleibende Bitbudget nicht zum Konfigurieren eines einer Kodierungseinheit in einer zweiten Komprimierungseinheit (202) zugeordneten Bitbudgets verwendet wird, wobei sich die erste Komprimierungseinheit (201) von der zweiten Komprimierungseinheit (202) unterscheidet.

4. Datenverarbeitungsvorrichtung (102) nach Anspruch 1, wobei das fehlerresistente Kodierungswerkzeug umfasst:
Einfügen mindestens einer Re-Synchronisationsmarkierung in die komprimierten Anzeigedaten (D1'), wobei die mindestens eine Re-Synchronisationsmarkierung in den komprimierten Anzeigedaten (D1') eindeutig identifizierbar ist.

5. Datenverarbeitungsvorrichtung (102) nach Anspruch 1, wobei das fehlerresistente Kodierungswerkzeug umfasst:
Berechnen von mindestens einem Fehlerkorrekturkode basierend auf den komprimierten Anzeigedaten (D1'); und
Hinzufügen vom mindestens einen Fehlerkorrekturkode in die komprimierten Anzeigedaten (D1').

6. Datenverarbeitungsvorrichtung (102) nach Anspruch 1, wobei das fehlerresistente Kodierungswerkzeug umfasst:
Erzeugen einer Kopie von mindestens einem Teil der komprimierten Anzeigedaten (D1') zur Ausgangsschnittstelle (114).

7. Datenverarbeitungsvorrichtung (104) umfassend:
eine Eingangsschnittstelle (124), die zum Empfangen eines Eingangsbitstroms von der Anzeigeschnittstelle (103) und zum Entpacken des Eingangsbitstroms zu Eingangsanzeigedaten (D_IN2) eingerichtet ist; und
einen Dekomprimierer (127), der zum Durchführen einer Dekomprimierung basierend auf den von den Eingangsanzeigedaten (D_IN2) erhaltenen komprimierten Anzeigedaten (D2') eingerichtet ist, um dekomprimierte Anzeigedaten (D4) zu erzeugen,
**dadurch gekennzeichnet, dass**:
die Anzeigeschnittstelle (103) eine durch eine mobile Industrie-Prozessorschnittstelle, MIPI, standardisierte serielle Anzeigeschnittstelle, DSI, oder ein durch eine Vereinigung für Videoelektronik-Standards, VESA, standardisierter eingebetteter Anzeigeport, eDP, ist; und
eine Fehlererkennung und eine Fehlerverdeckung an der Dekomprimierung beteiligt sind; und
die komprimierten Anzeigedaten Komprimierungsdaten einer Komprimierungseinheit (203, 204) in einem Bild (IMG) umfassen, die komprimierten Daten der Komprimierungseinheit (203, 204) eine Mehrzahl von Datensegmenten umfassen, wobei die Datensegmente mindestens ein erstes Datensegment mit einer ersten Priorität und ein zweites Datensegment mit einer zweiten Priorität umfassen, und eine Fehlererkennungsfähigkeit und eine Fehlerkorrekturfähigkeit des ersten Datensegments und des zweiten Datensegments basierend auf einer Prioritätsreihenfolge der ersten Priorität und der zweiten Priorität konfiguriert sind.

8. Datenverarbeitungsvorrichtung (104) nach Anspruch 7, wobei die Fehlererkennung umfasst:
Erkennen eines Fehlers bzw. von Fehlern in den komprimierten Anzeigedaten durch Prüfen mindestens eines Fehlerkorrekturkodes der komprimierten Anzeigedaten.

9. Datenverarbeitungsvorrichtung (104) nach Anspruch 7, wobei die Fehlererkennung umfasst:
Erkennen eines Fehlers bzw. von Fehlern in den komprimierten Anzeigedaten durch Prüfen eines Auftretens von mindestens einer unzulässigen Syntax in den komprimierten Anzeigedaten.

10. Datenverarbeitungsvorrichtung (104) nach Anspruch 7, wobei die Fehlererkennung umfasst:
Erkennen eines Fehlers bzw. von Fehlern in den dekomprimierten Anzeigedaten (D4) durch Prüfen der Glätte von mindestens einer Grenze, wobei die mindestens eine Grenze zwischen zwei dekomprimierten Komprimierungseinheiten (203, 204), oder zwischen zwei dekomprimierten Kodierungseinheiten in derselben Komprimierungseinheit (203, 204) liegt.

11. Datenverarbeitungsvorrichtung (104) nach Anspruch 7, wobei die dekomprimierten Anzeigedaten (D4) dekomprimierte Daten eines Bildes (F_{N}) umfassen, und die Fehlerverdeckung umfasst:
Verdecken einer ersten dekomprimierten Komprimierungseinheit mit einem Fehler bzw. mit Fehlern (1302) durch eine zweite dekomprimierte Komprimierungseinheit (1301), wobei sich die erste dekomprimierte Komprimierungseinheit und die zweite dekomprimierte Komprimierungseinheit in dem Bild (F_{N}) befinden; oder
Verdecken einer ersten dekomprimierten Komprimierungseinheit mit einem Fehler bzw. mit Fehlern (1402) durch eine interpolierte Komprimierungseinheit (1401), wobei die interpolierte Komprimierungseinheit durch eine Interpolierung von mindestens einer zweiten dekomprimierten Komprimierungseinheit erhalten wird, und sich die erste dekomprimierte Komprimierungseinheit und die mindestens eine zweite dekomprimierte Komprimierungseinheit in dem Bild (F_{N}) befinden.

12. Datenverarbeitungsvorrichtung (104) nach Anspruch 7, wobei die dekomprimierten Anzeigedaten (D4) dekomprimierte Daten eines ersten Bildes (F_{N-1}) und dekomprimierte Daten eines zweiten Bildes (F_{N}) umfassen, und die Fehlerverdeckung umfasst:
Verdecken einer ersten dekomprimierten Komprimierungseinheit mit einem Fehler bzw. mit Fehlern (1503) durch eine zweite dekomprimierte Komprimierungseinheit (1501), wobei sich die erste dekomprimierte Komprimierungseinheit in einem von dem ersten Bild (F_{N-1}) und dem zweiten Bild (F_{N}) befindet, und sich die zweite dekomprimierte Komprimierungseinheit in einem anderen von dem ersten Bild (F_{N-1}) und dem zweiten Bild (F_{N}) befindet.

13. Datenverarbeitungsverfahren umfassend:
Verwenden eines Komprimierers (117) zum Durchführen einer Komprimierung basierend auf Eingangsanzeigedaten (D3), um komprimierte Anzeigedaten (D1') zu erzeugen;
Packen von Ausgangsanzeigedaten (D_OUT1), die von den komprimierten Anzeigedaten (D1') in einen Ausgangsbitstrom erhalten werden; und
Ausgeben des Ausgangsbitstroms durch eine Anzeigeschnittstelle (103),
**dadurch gekennzeichnet, dass**:
ein fehlerresistentes Kodierungswerkzeug an der Komprimierung beteiligt ist;
die Anzeigeschnittstelle (103) eine durch eine mobile Industrie-Prozessorschnittstelle, MIPI, standardisierte serielle Anzeigeschnittstelle, DSI, oder ein durch eine Vereinigung für Videoelektronik-Standards, VESA, standardisierter eingebetteter Anzeigeport, eDP, ist; und
die komprimierten Anzeigedaten (D1') Komprimierungsdaten einer Komprimierungseinheit (203, 204) in einem Bild (IMG) umfassen, und das fehlerresistente Kodierungswerkzeug umfasst:
Partitionieren und Organisieren der komprimierten Daten der Komprimierungseinheit (203, 204) in eine Mehrzahl von Datensegmenten, wobei die Datensegmente mindestens ein erstes Datensegment mit einer ersten Priorität und ein zweites Datensegment mit einer zweiten Priorität umfassen; und
Konfigurieren der Fehlererkennungsfähigkeit und der Fehlerkorrekturfähigkeit des ersten Datensegments und des zweiten Datensegments basierend auf einer Prioritätsreihenfolge der ersten Priorität und der zweiten Priorität.

14. Datenverarbeitungsverfahren umfassend:
Empfangen eines Eingangsbitstroms von einer Anzeigeschnittstelle (103);
Entpacken des Eingangsbitstroms zu Eingangsanzeigedaten (D_IN2); und
Verwenden eines Dekomprimierers (127) zum Durchführen einer Dekomprimierung basierend auf den von den Eingangsanzeigedaten (D_IN2) erhaltenen komprimierten Anzeigedaten (D2'), um dekomprimierte Anzeigedaten (D4) zu erzeugen,
**dadurch gekennzeichnet, dass**:
die Anzeigeschnittstelle (103) eine durch eine mobile Industrie-Prozessorschnittstelle, MIPI, standardisierte serielle Anzeigeschnittstelle, DSI, oder ein durch eine Vereinigung für Videoelektronik-Standards, VESA, standardisierter eingebetteter Anzeigeport, eDP, ist;
eine Fehlererkennung und eine Fehlerverdeckung an der Dekomprimierung beteiligt sind; und
die komprimierten Anzeigedaten Komprimierungsdaten einer Komprimierungseinheit (203, 204) in einem Bild (IMG) umfassen, die komprimierten Daten der Komprimierungseinheit (203, 204) eine Mehrzahl von Datensegmenten umfassen, wobei die Datensegmente mindestens ein erstes Datensegment mit einer ersten Priorität und ein zweites Datensegment mit einer zweiten Priorität umfassen, und eine Fehlererkennungsfähigkeit und eine Fehlerkorrekturfähigkeit des ersten Datensegments und des zweiten Datensegments basierend auf einer Prioritätsreihenfolge der ersten Priorität und der zweiten Priorität konfiguriert werden.

## Revendications

1. Appareil de traitement de données (102) comprenant :
un compresseur (117), agencé pour effectuer une compression sur des données d'affichage d'entrée (D3) afin de générer des données d'affichage compressées (D1') ; et
une interface de sortie (114), agencée pour condenser des données d'affichage de sortie (D_OUT1) dérivées des données d'affichage compressées (D1') dans un train de bits de sortie, et pour délivrer en sortie le train de bits de sortie via une interface d'affichage (103),
**caractérisé en ce que** :
un outil de codage résistant aux erreurs est impliqué dans la compression ;
l'interface d'affichage (103) est l'un(e) d'une interface série d'affichage, DSI, normalisée par une Interface de Processeur d'Industrie Mobile, MIPI, et d'un port d'affichage intégré, eDP, normalisé par l'Association Video Electronics Standards Association (VESA) ; et
les données d'affichage compressées (D1') comprennent des données de compression d'une unité de compression (203, 204) dans une trame (IMG), et l'outil de codage résistant aux erreurs comprend le fait :
de partitionner et d'organiser les données compressées de l'unité de compression (203, 204) en une pluralité de segments de données, où les segments de données comportent au moins un premier segment de données avec une première priorité et un deuxième segment de données avec une deuxième priorité ; et
de configurer la capacité de détection et de correction d'erreur des premier et deuxième segments de données sur la base d'un ordre de priorité des première et deuxième priorités.

2. Appareil de traitement de données de la revendication 1, dans lequel les données d'affichage d'entrée (D3) comprennent des données d'affichage d'une trame (IMG), et l'outil de codage résistant aux erreurs comprend le fait :
de partitionner une région (R) dans la trame (IMG) en une pluralité de sous-régions (S01 à S08, S11 à S18) ; et
de sélectionner de sous-régions entrelacées (S01, S12, S03, S14, S05, S16, S07 et S18 ; S11, S02, S13, S04, S15, S06, S17 et S08) parmi les sous-régions (S01 à S08, S11 à S18) pour former une unité de compression (203, 204).

3. Appareil de traitement de données (102) de la revendication 1, dans lequel les données d'affichage d'entrée (D3) comprennent des données d'affichage d'une trame (IMG), et l'outil de codage résistant aux erreurs comprend le fait :
de bloquer une prédiction intra-unité de compression fournie par une première unité de codage dans une unité de compression (201, 202) de la trame pour qu'elle ne soit pas utilisée pour le codage d'une deuxième unité de codage dans l'unité de compression, où la deuxième unité de codage est différente de la première unité de codage ; ou
de bloquer une prédiction inter-unité de compression fournie par une unité de codage dans une première unité de compression (201) de la trame pour qu'elle ne soit pas utilisée pour le codage d'une unité de codage dans une deuxième unité de compression (202) de la trame, où la première unité de compression (201) est différent de la deuxième unité de compression (202) ; ou
de bloquer un budget de bits restant qui reste du codage d'une première unité de codage dans une unité de compression (201, 202) de la trame pour qu'il ne soit pas utilisé pour la configuration d'un budget de bits alloué à une deuxième unité de codage dans l'unité de compression (201, 202), où la deuxième unité de codage est différente de la première unité de codage ; ou
de bloquer un budget de bits restant qui reste du codage d'une unité de codage dans une première unité de compression (201) de la trame pour qu'il ne soit pas utilisé pour la configuration d'un budget de bits alloué à une unité de codage dans une deuxième unité de compression (202) de la trame, où la première unité de compression (201) est différente de la deuxième unité de compression (202).

4. Appareil de traitement de données (102) de la revendication 1, dans lequel l'outil de codage résistant aux erreurs comprend le fait :
d'insérer au moins un marqueur de resynchronisation dans les données d'affichage compressées (D1'), où l'au moins un marqueur de resynchronisation peut être identifié de manière unique dans les données d'affichage compressées (D1').

5. Appareil de traitement de données (102) de la revendication 1, dans lequel l'outil de codage résistant aux erreurs comprend le fait :
de calculer au moins un code de correction d'erreur en fonction des données d'affichage compressées (D1') ; et
d'ajouter au moins un code de correction d'erreur aux données d'affichage compressées (D1').

6. Appareil de traitement de données (102) de la revendication 1, dans lequel l'outil de codage résistant aux erreurs comprend le fait :
de générer une copie d'au moins une partie des données d'affichage compressées (D1') pour l'interface de sortie (114).

7. Appareil de traitement de données (104) comprenant :
une interface d'entrée (124), agencée pour recevoir un train de bits d'entrée à partir d'une interface d'affichage (103), et pour décondenser le train de bits d'entrée dans des données d'affichage d'entrée (D_IN2) ; et
un décompresseur (127), agencé pour effectuer une décompression sur des données d'affichage compressées (D2') dérivées des données d'affichage d'entrée (D_IN2) afin de générer des données d'affichage décompressées (D4),
**caractérisé en ce que** :
l'interface d'affichage (103) est l'un(e) d'une interface série d'affichage, DSI, normalisée par une Interface de Processeur d'Industrie Mobile, MIPI, et d'un port d'affichage intégré, eDP, normalisé par l'Association Video Electronics Standards Association (VESA) ;
une détection d'erreur et une dissimulation d'erreur sont impliquées dans la décompression ; et
les données d'affichage compressées comprennent des données de compression d'une unité de compression (203, 204) dans une trame (IMG), les données compressées de l'unité de compression (203, 204) comportent une pluralité de segments de données, où les segments de données comportent au moins un premier segment de données avec une première priorité et un deuxième segment de données avec une deuxième priorité, et une capacité de détection et de correction d'erreur des premier et deuxième segments de données est configurée sur la base d'un ordre de priorité des première et deuxième priorités.

8. Appareil de traitement de données (104) de la revendication 7, dans lequel la détection d'erreur comprend le fait :
de détecter une ou plusieurs erreur(s) dans les données d'affichage compressées en vérifiant au moins un code de correction d'erreur des données d'affichage compressées.

9. Appareil de traitement de données (104) de la revendication 7, dans lequel la détection d'erreur comprend le fait :
de détecter une ou plusieurs erreur(s) dans les données d'affichage compressées en vérifiant l'occurrence d'au moins une syntaxe illégale dans les données d'affichage compressées.

10. Appareil de traitement de données (104) de la revendication 7, dans lequel la détection d'erreur comprend le fait :
de détecter une ou plusieurs erreur(s) dans les données d'affichage décompressées (D4) en vérifiant le lissage d'au moins une limite, où l'au moins une limite est située entre deux unités de compression décompressées (203, 204) ou entre deux unités de codage décompressées dans une même unité de compression (203, 204).

11. Appareil de traitement de données (104) de la revendication 7, dans lequel les données d'affichage décompressées (D4) comprennent des données décompressées d'une trame (F_{N}), et la dissimulation d'erreur comprend le fait :
de dissimuler une première unité de compression décompressée avec une ou plusieurs erreur(s) (1302) par une deuxième unité de compression décompressée (1301), où la première unité de compression décompressée et la deuxième unité de compression décompressée se trouvent dans la trame (F_{N}) ; ou
de dissimuler une première unité de compression décompressée avec une ou plusieurs erreur(s) (1402) par une unité de compression interpolée (1401), où l'unité de compression interpolée est dérivée de l'interpolation d'au moins une deuxième unité de compression décompressée, et la première unité de compression compressée et l'au moins une deuxième unité de compression décompressée se trouvent dans la trame (F_{N}).

12. Appareil de traitement de données (104) de la revendication 7, dans lequel les données d'affichage décompressées (D4) comprennent des données décompressées d'une première trame (F_{N-1}) et des données décompressées d'une deuxième trame (F_{N}), et la dissimulation d'erreur comprend le fait :
de dissimuler une première unité de compression décompressée avec une ou plusieurs erreur(s) (1503) par une deuxième unité de compression décompressée (1501), où la première unité de compression décompressée se trouve dans l'une de la première trame (F_{N-1}) et de la deuxième trame (F_{N}), et la deuxième unité de compression décompressée se trouve dans une autre de la première trame (F_{N-1}) et de la deuxième trame (F_{N}).

13. Procédé de traitement de données comprenant le fait :
d'utiliser un compresseur (117) pour effectuer une compression sur des données d'affichage d'entrée (D3) afin de générer des données d'affichage compressées (D1') ;
de condenser des données d'affichage de sortie (D_OUT1) dérivées des données d'affichage compressées (DT) dans un train de bits ; et
de livrer en sortie le train de bits de sortie via une interface d'affichage (103),
**caractérisé en ce que** :
un outil de codage résistant aux erreurs est impliqué dans la compression ;
l'interface d'affichage (103) est l'un(e) d'une interface série d'affichage, DSI, normalisée par une Interface de Processeur d'Industrie Mobile, MIPI, et d'un port d'affichage intégré, eDP, normalisé par l'Association Video Electronics Standards Association (VESA) ; et
les données d'affichage compressées (D1') comprennent des données de compression d'une unité de compression (203, 204) dans une trame (IMG), et l'outil de codage résistant aux erreurs comprend le fait :
de partitionner et d'organiser les données compressées de l'unité de compression (203, 204) en une pluralité de segments de données, où les segments de données comportent au moins un premier segment de données avec une première priorité et un deuxième segment de données avec une deuxième priorité ; et
de configurer la capacité de détection et de correction d'erreur des premier et deuxième segments de données sur la base d'un ordre de priorité des première et deuxième priorités.

14. Procédé de traitement de données comprenant le fait :
de recevoir un train de bits d'entrée à partir d'une interface d'affichage (103) ;
de décondenser le train de bits d'entrée dans des données d'affichage d'entrée (D_IN2) ; et
d'utiliser un décompresseur (127) pour effectuer une décompression sur des données d'affichage compressées (D2') dérivées des données d'affichage d'entrée (D_IN2) afin de générer des données d'affichage décompressées (D4),
**caractérisé en ce que** :
l'interface d'affichage (103) est l'un(e) d'une interface série d'affichage, DSI, normalisée par une Interface de Processeur d'Industrie Mobile, MIPI, et d'un port d'affichage intégré, eDP, normalisé par l'Association Video Electronics Standards Association (VESA) ;
une détection d'erreur et une dissimulation d'erreur sont impliquées dans la décompression ; et
les données d'affichage compressées comprennent des données de compression d'une unité de compression (203, 204) dans une trame (IMG), les données compressées de l'unité de compression (203, 204) comportent une pluralité de segments de données, où les segments de données comportent au moins un premier segment de données avec une première priorité et un deuxième segment de données avec une deuxième priorité, et une capacité de détection et de correction d'erreur des premier et deuxième segments de données est configurée sur la base d'un ordre de priorité des première et deuxième priorités.
